# FASCICULE DE BREVET EUROPEEN

(11) **EP 0 916 144 B1**
(45) Date de publication et mention de la délivrance du brevet: **12.03.2003**
(21) Numéro de dépôt: 98921320.2
(22) Date de dépôt: 02.06.1998
(51) Int. Cl.: H01F 41/04, H05K 3/04

(54) **PROCEDE DE FABRICATION DE BOBINE POUR TRANSPONDEURS**
HERSTELLUNGSVERFAHREN FÜR EINE TRANSPONDERSPULE
METHOD FOR MAKING A TRANSPONDER COIL

(30) Priorité: 03.06.1997 CH 131997; 10.06.1997 CH 131997
(43) Date de publication de la demande: 19.05.1999
(73) Titulaire: NagraID S.A., 2301 La Chaux-de-Fonds (CH)
(72) Inventeur: Droz, Francois, 2300 La Chaux-de-Fonds (CH)
(74) Mandataire: Wenger, Joel-Théophile
(86) Numéro de dépôt international: CH9800231
(87) Numéro de publication internationale: WO98056019

(56) Documents cités:
- DE-A- 1 690 542
- DE-A- 4 410 732
- US-A- 2 622 054
- US-A- 4 023 998
- US-A- 5 184 111

## Description

### Domaine technique

La présente invention concerne un procédé de fabrication de bobine pour transpondeurs selon le préambule de la revendication 1. Plus précisément, la présente invention concerne un procédé de fabrication de bobine pour transpondeurs, par exemple pour cartes à puces.

### Technique antérieure

Dans la technique des transpondeurs, notamment des cartes à puces de type transpondeur, on souhaite souvent associer une bobine d'inductance à un circuit électronique, par exemple à un circuit intégré, monté sur une plaque de circuit imprimé. Une telle configuration est décrite par exemple dans WO-91/19302. La bobine est généralement réalisée par bobinage d'un fil autour d'un noyau. De telles bobines sont complexes à réaliser, donc relativement coûteuses. En outre, la connexion entre le circuit imprimé et la bobine occasionne certaines difficultés de montage supplémentaires et pose des problèmes de fiabilité, notamment lorsque ces éléments sont intégrés dans une carte à puce n'offrant pas de protection efficace face aux déformations et aux contraintes mécaniques. D'autre part, l'épaisseur de la bobine rend difficile son intégration dans une carte à puce d'épaisseur normalisée à 0,76 mm.

On connaît aussi des bobines dont les spires sont constituées directement par les pistes conductrices d'un circuit imprimé, permettant ainsi d'éviter toute soudure. Les pistes du circuit imprimées sont généralement réalisées par voie photochimique, ce qui nécessite de nombreuses opérations coûteuses et utilise des produits polluants.

US 4 555 291 décrit un procédé de fabrication de bobine essentiellement mécanique. Un film métallique fin est préalablement découpé en forme de spirale. Les différentes spires ne sont pas totalement séparées afin de rigidifier la spirale découpée. La spirale est ensuite fixée sur une feuille de matériau diélectrique, et un deuxième dispositif de coupe est mis en oeuvre pour supprimer les interconnexions entre spires, laissant subsister un circuit de nature inductive.

Cette solution est complexe à appliquer et nécessite notamment deux opérations de découpe distinctes. L'épaisseur du film métallique prédécoupé doit être suffisante pour pouvoir être transporté sans se déformer ou se déchirer; de même, la largeur des spires et des intervalles découpés entre les spires doit être suffisante pour assurer un minimum de rigidité au film avant stratification sur le support diélectrique.

On connaît d'autres procédés de fabrication de bobines à partir d'un film synthétique revêtu d'une couche conductrice superficielle, dans lesquels les différentes spires sont démarquées par étampage mécanique de ladite couche conductrice effectué au moyen d'une matrice d'étampage. US2'622'054, EP0096516 ou GB610058 par exemple décrivent des variantes d'un tel procédé. Il est difficile d'obtenir des pistes de largeur très réduites avec ces techniques d'étampage. En outre, le film synthétique doit avoir une épaisseur suffisante pour supporter la pression d'étampage et rester suffisamment rigide même dans les régions repoussées par la matrice d'étampage.

DE-2 758 204 décrit un procédé de fabrication de circuit imprimé, en particulier d'inductance, dans lequel les différentes pistes constituant les spires de la bobine sont démarquées par usinage thermomécanique d'un film synthétique revêtu d'une couche métallique superficielle. Une pointe métallique chauffée traverse la couche de métal superficielle et fait simultanément fondre une partie de la couche synthétique sous le métal.

Le procédé décrit dans le document ci-dessus est plus spécialement adapté pour réaliser différentes sortes de dispositifs ou pour des bobines dont l'épaisseur n'est pas critique. L'épaisseur de la couche synthétique (1) doit être suffisamment épaisse pour être entaillée par la pointe (3) et simultanément chauffée sans être traversée complètement. La régulation de la température de la pointe pose des difficultés supplémentaires; en outre, la pointe métallique (3) doit se déplacer suffisamment lentement pour que le matériau synthétique ait le temps de fondre. Ce procédé est donc inadapté pour fabriquer des bobines devant être par exemple intégrées dans des cartes à puces, et dont l'épaisseur aussi bien que le coût et le temps de fabrication doivent être minimisés.

La demande de brevet W098/04105, décrit un procédé de fabrication de transpondeur, en particulier de carte à puce, comportant une bobine fabriquée par étampage d'une feuille comportant une couche conductrice, sans repoussement de matière vers la profondeur ni retrait de matière conductrice. Le poinçon d'étampage présente des surfaces de contact coupantes avec la couche conductrice. Ce procédé permet d'obtenir de façon très économique des bobines extrêmement minces pouvant être insérées par exemple dans des cartes à puces. La largeur des entailles est suffisamment réduite pour obtenir un nombre de spires élevé même sur une surface aussi limitée que celle d'un transpondeur ou d'une carte à puce.

Un but de la présente invention est donc de proposer une amélioration au procédé de fabrication de bobine décrit dans la demande W098/04105 susmentionnée, en particulier un procédé permettant d'augmenter encore la densité des spires de la bobine sur un transpondeur et/ou de réduire l'épaisseur de la bobine.

### Exposé de l'invention

Selon un aspect de l'invention, ce but est atteint au moyen d'un procédé de fabrication de circuit imprimé tel que spécifié par la revendication 1.

L'invention part de la constatation que, dans le dispositif décrit dans la demande W098/04105, il est difficile d'obtenir une découpe nette et franche des entailles délimitant les spires d'une bobine. La difficulté provient de la ductilité des métaux utilisés pour la couche conductrice. Le poinçon d'étampage tend, lorsqu'il est abaissé, à enfoncer et déformer la couche conductrice sans immédiatement la découper. Lorsque la pression est suffisante, la couche conductrice se déchire brusquement sous le poinçon. Les arêtes au bord de l'entaille étampée par ce procédé sont peu propres et comportent parfois des bavures; des entailles fines et peu profondes sont par conséquent difficiles à étamper, en particulier lorsque le poinçon d'étampage n'est pas parfaitement aiguisé. Pour réduire le risque de court-circuit entre les spires de chaque côté de l'entaille, il est nécessaire de remplacer souvent le poinçon et d'étamper des entailles de largeur relativement importante, par exemple en abaissant davantage le poinçon, ce qui va à l'encontre de l'objectif de maximiser la densité des spires et de limiter l'épaisseur de la bobine.

En outre, il est difficile de laminer une couche de protection de la carte à puce, généralement en PVC, par dessus la couche conductrice, généralement en aluminium. Le problème est particulièrement critique lorsque la feuille d'aluminium n'est pas rigoureusement plane.

Selon l'invention, ces difficultés sont éliminées en recouvrant préalablement la couche conductrice destinée à être étampée par un film superficiel, par exemple par un film synthétique.

Des essais ont montré que ce film superficiel permet de faciliter considérablement l'étampage des entailles, et d'obtenir avec un poinçon identique et une profondeur de pénétration équivalente des arêtes au bord des entailles beaucoup plus propres.

En insérant en outre un matériau isolant dans les entailles étampées, par exemple un enduit, de la colle ou le matériau d'une couche supérieure laminée, il est en outre possible de garantir une isolation optimale entre spires adjacentes.

Ce procédé permet par conséquent d'éviter les inconvénients mentionnés des procédés de l'art antérieur.

### Description sommaire des dessins.

D'autres aspects et avantages de l'invention ressortiront de la description donnée à titre d'exemple et illustrée par les figures annexées qui montrent:
Les figures 1 à 6 une vue en coupe d'une portion de bobine au cours de six étapes successives de fabrication.
La figure 7 une vue en perspective d'une carte à puce comprenant un circuit imprimé selon un premier mode de réalisation de la connexion entre la bobine et un composant électronique représentés tout deux en transparence.
La figure 8 une vue en perspective d'une carte à puce comprenant un circuit imprimé selon un deuxième mode de réalisation de la connexion entre la bobine et un composant électronique représentés tous deux en transparence.

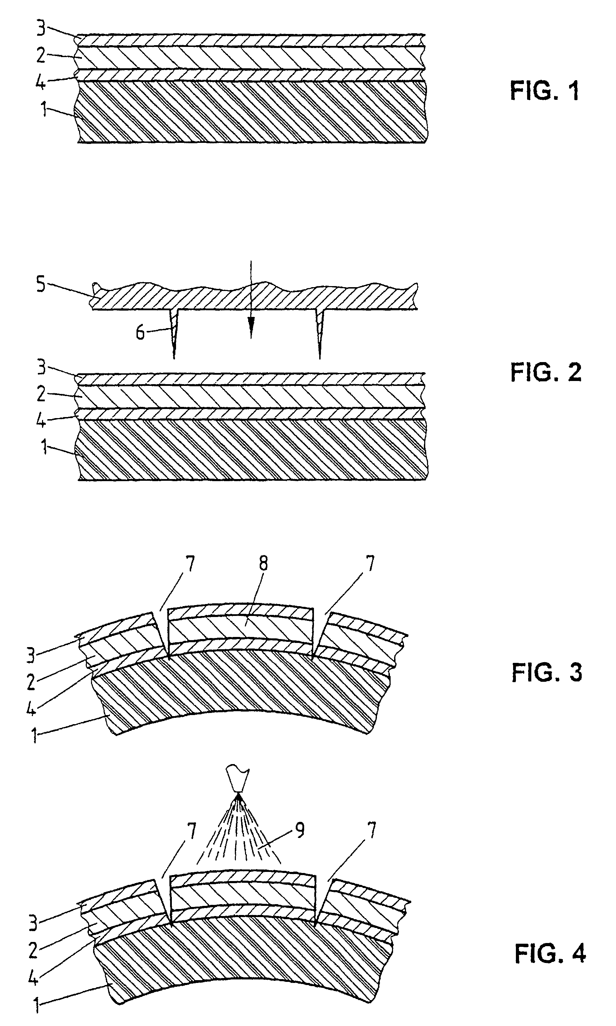

La figure 1 illustre une vue en coupe d'une feuille 1, 4, 2. La feuille 1, 4, 2 est constituée de préférence d'un substrat diélectrique 1 quelconque, par exemple d'un matériau synthétique type PVC ou de carton, revêtu d'une couche conductrice superficielle 2. Selon l'application, on choisira un film souple ou au contraire un substrat plus rigide. Le substrat 1 peut aussi être constitué d'un matériau composite ou multicouche, par exemple d'un stratifié comprenant plusieurs couches de matériau, ou comporter des renforts locaux. par exemple en epoxy, fibre de verre, fibre de carbone, etc..., par exemple dans la zone destinée à recevoir le composant électronique.

La couche conductrice superficielle 2 est appliquée par un procédé connu sur la couche 1 et maintenue par exemple par soudage ou au moyen de colle 4. La colle 4 peut par exemple être une colle à chaud, une colle à froid ou une colle durcissant par exposition aux UV; il est aussi possible d'utiliser en guise de colle 4 une feuille adhésive double face ou un film thermocollant. La couche 2 est réalisée en un métal approprié, par exemple en cuivre, en aluminium, en argent ou en alliage conducteur, ou au moyen d'une encre conductrice.

De manière optionnelle, le substrat diélectrique 1 peut être muni de trous traversants que vient remplir le métal de la couche 2 lors du laminage sous pression. Ainsi, des points de contact électrique sur la face inférieure de la feuille 1, 4, 2 peuvent être réalisés de manière économique. Dans une variante, les trous peuvent être métallisés au moyen d'un insert rapporté.

Selon l'invention, la face supérieure (opposée au substrat) de la couche conductrice 2 est recouverte préalablement au moins partiellement par un film 3, par exemple par un film en matériau synthétique. Des feuilles métalliques, par exemple des feuilles d'aluminium, recouvertes d'une mince couche de protection synthétique sont largement disponibles dans le commerce. La fonction de ce film 3 est principalement, comme on le verra, de faciliter l'étampage des entailles démarquant les pistes et d'améliorer la qualité des entailles obtenues. Il est aussi possible de déposer le film 3 sur la couche conductrice 2 après laminage de la couche 2 et du substrat 1, par exemple juste avant l'étampage.

La figure 2 représente une vue en coupe d'un poinçon d'étampage 5 au-dessus de la portion de feuille 1, 2, 3, 4, avant démarcation des pistes conductrices. Le poinçon d'étampage 5 présente des surfaces de contact coupantes 6 avec la couche superficielle 3.

Le poinçon d'étampage 5 est abaissé grâce à des moyens non représentés, avec une pression juste suffisante pour que les surfaces de contact coupantes 6 perforent et découpent la couche métallique superficielle 2. Des butées mécaniques peuvent aussi être utilisées pour contrôler l'abaissement. Le profil des surfaces 6 est suffisamment aiguisé pour que le poinçon découpe des entailles 7 fines dans la couche 2, sans retirer de matière conductrice comme dans les procédés de fraisage ni repoussement vers la profondeur comme dans les procédés d'étampage du type GB1138628. La matière métallique est ici incisée par les surfaces 6.

La figure 3 illustre une vue en coupe de la portion de feuille 1, 2, 3 4 revêtue d'une couche métallique 2 après démarcation des pistes conductrices 8. On voit que les entailles 7 sont juste assez profondes pour traverser le film 3, la couche métallique 2, la couche de colle 4 et éventuellement effleurer la couche diélectrique synthétique 1. Dans une variante, les entailles 7 ne traversent complètement que le film 3 et la couche métallique superficielle, le fond des entailles étant au milieu de la couche de colle 4. De cette manière, le film synthétique 1 est aussi peu affaibli que nécessaire par l'usinage des démarcations entre pistes conductrices 8 et peut avoir une épaisseur minimale.

Dans une variante non illustrée de l'invention, le film 3 destiné à faciliter l'usinage d'entailles propres est retiré après l'opération d'étampage, afin de réduire au maximum l'épaisseur de la carte. Dans ce but, le film 3 n'est pas nécessairement collé sur la couche métallique 2. ou n'est du moins pas collé au moyen d'une colle permanente.

L'étampage provoque un repoussement latéral de la matière dans les entailles 7. Ce repoussement de matière provoque un cintrage de la feuille 1, 2, 3, 4, fortement exagéré sur la figure 3, en sorte que les entailles 7 bâillent largement.

Pour optimiser la densité des pistes conductrices 8 sur le circuit imprimé, la largeur des entailles 7 est aussi fine que possible. La couche superficielle 3 permet d'obtenir une découpe très franche des entailles, en sorte que le risque de court-circuit entre pistes conductrices 8 par des bavures de découpe est fortement réduit.

Le poinçon d'étampage comporte une surface de découpe 6 en spirale et découpe dans la couche conductrice 2 un élément inductif (bobine) dont les spires sont constituées par les pistes conductrices du circuit imprimé. Des opérations d'usinage supplémentaires traditionnelles, par exemple de perçage et de soudage, peuvent ensuite être effectuées pour fixer des composants discrets sur le circuit imprimé ainsi réalisé.

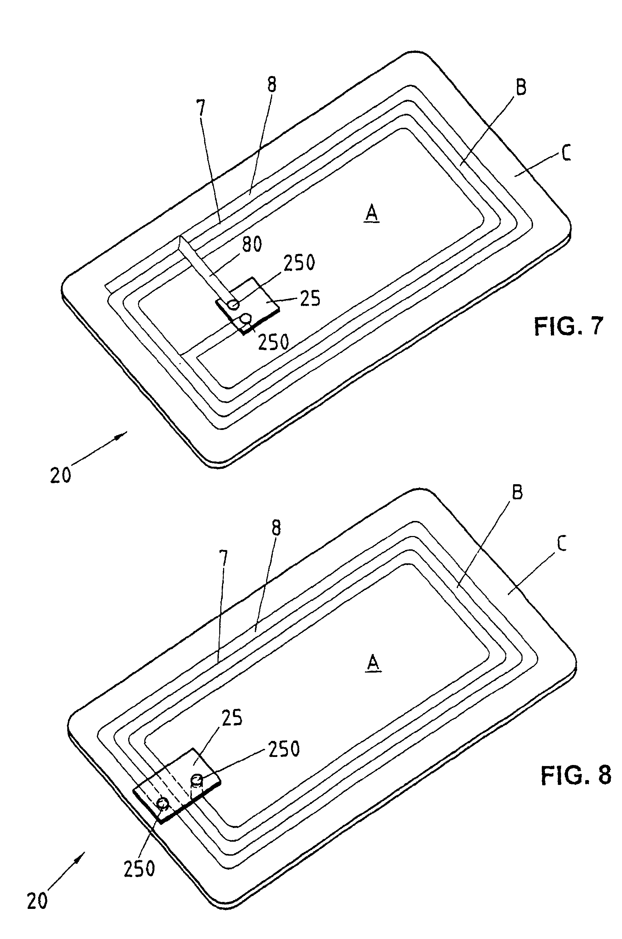

Au cours de l'étape de fabrication suivante, qui n'est pas illustrée ici, certaines zones prédécoupées de la couche conductrice 2 sont de préférence décollées et retirées de manière à ne conserver que des portions utiles de la couche conductrice 2. Les zones décollées peuvent comporter par exemple la zone métallique A (figures 7 et 8) à l'intérieur de la bobine entre les spires, la zone C à l'extérieur de la bobine, ou un segment desdites spires. En supprimant les portions A et C à l'intérieur, respectivement à l'extérieur des spires, on évite que ces portions de forme mal contrôlées ne perturbent les lignes de champ magnétique de la bobine et ne modifient ainsi de manière difficilement prévisible les caractéristiques de la bobine. En décollant une portion B des spires, on peut par exemple ajuster l'inductance de la bobine. Il est aussi possible d'ajuster l'inductance de la bobine par usinage des spires après étampage. Pour faciliter le décollement, on utilisera de préférence une colle 4 non permanente entre la couche conductrice 2 et le substrat 1, permettant de décoller facilement par pelage les portions A, B, C désirées. Dans un autre mode de réalisation, il est aussi possible préalablement de n'encoller que les portions de la couche métallique 2 destinées à être conservées sur le substrat 1, et de ne pas coller les portions résiduelles destinées à être retirées.

La couche de diélectrique, par exemple de PVC, devient apparente dans les portions de la carte A, B, C où la couche métallique 2 a été décollée, avec les deux couches 3 et/ou 4 associées. Le laminage (décrit plus loin) d'une couche de protection 22 par-dessus la carte est ainsi grandement facilité, puisque la couche de protection est généralement choisie dans le même matériau diélectrique que la couche 1. En particulier, si la portion C de la couche conductrice est décollée, l'adhésion des couches 1 et 22 est assurée dans les bords de la carte.

Après la découpe des entailles 7, le procédé selon l'invention comporte de préférence une étape d'insertion de matériau isolant dans les entailles 7, afin d'éviter que les entailles ne se referment lors de déformations de la carte. Sur la figure 4, les entailles sont remplies au moyen d'un enduit, par exemple d'un vernis, d'une laque, d'une résine ou d'un matériau préimprégné 9 par exemple, pulvérisé par sprayage sur la surface de la feuille 1, 2, 3, 4, collé ou appliqué par sérigraphie. Les entailles pourraient cependant aussi être remplies et isolées avec n'importe quel matériau isolant. Par exemple, la surface de la feuille 1, 2, 3, 4 pourrait être enduite avec une colle à froid ou à chaud suffisamment liquide pour pénétrer également au fond des entailles 7, et permettant de coller une couche de protection supérieure sur la surface de la bobine découpée. En raison de l'écartement maximal des entailles, dû au cintrage de la feuille, le matériau choisi 9 pénètre aisément jusqu'au fond des entailles 7. Le matériau 9 permet de compenser largement les inégalités de hauteur de la feuille 1, 2, 3, 4 découpée. Il est aussi possible de remplir partiellement les entailles 9 avec le matériau de la couche supérieure laminée ultérieurement, comme décrit plus bas.

Lorsque le risque de court-circuit entre spires voisines est important, par exemple dans le cas de substrat souple, il est possible de retirer (par exemple par décollement) une portion de la couche conductrice entre les spires. Dans ce cas, il est nécessaire de découper deux entailles entre les spires à isoler et de décoller le métal entre ces deux entailles.

L'étape de fabrication suivante, qui est facultative et non illustrée ici, consiste à redresser la feuille 1, 2, 3, 4 en la comprimant entre deux plaques, éventuellement à haute température, de manière à compenser le cintrage.

Dans un premier mode d'exécution, la pression appliquée au cours de cette opération de correction du cintrage est suffisante pour enfoncer les portions non décollées de la couche conductrice 2, 3, 4 dans l'épaisseur du diélectrique 1. Il est possible de repousser la couche 2 jusqu'à ce qu'elle vienne à fleur de la surface supérieure de la couche de diélectrique 1, améliorant ainsi sensiblement la planéité de l'empilage.

Dans un second mode d'exécution, la différence de hauteur résultant du décollement des portions A, B, et/ou C de la couche conductrice 2 est compensée en laminant par-dessus la couche de diélectrique 1 une feuille de diélectrique intermédiaire non représentée ayant sensiblement l'épaisseur des couches 2, 3, 9 et dont la forme correspond à celle des portions A, B, C décollées.

Dans un troisième mode d'exécution, cette différence de hauteur est compensée préalablement, en laminant par-dessus le diélectrique 1, avant même l'application de la couche 2, 3, une feuille de diélectrique non représentée, ayant sensiblement l'épaisseur des couches 2, 3, 9 et dont la forme correspond à celle des portions A, B, C dépourvues de pistes. Dans ce cas, la couche conductrice 2, 3 est découpée à la forme désirée avant même son laminage sur la couche 1.

L'étape de fabrication suivante, qui n'est pas illustrée ici, implique l'assemblage d'au moins un composant électrique ou électronique sur la feuille 1, 2, 3, 4. Ce composant peut être fixé par n'importe quel moyen, par exemple par collage ou par bonding, sur la feuille. Dans un autre mode de réalisation, discuté plus en détail plus bas, le composant est simplement déposé à l'endroit approprié sur la feuille et ne sera maintenu que par la couche de protection supérieure. Il peut être nécessaire selon l'épaisseur du composant de prévoir un évidement dans la feuille 1, 2, 3, 4 pour loger le composant sans créer de renflement à la surface de la carte. Le logement peut par exemple être usiné, par exemple étampé, dans une ou plusieurs couches de la feuille 1, 2, 3, 4 avant, pendant, après le laminage de ces couches. Il est aussi possible d'usiner cet évidemment au moyen du poinçon d'étampage 5 qui dans ce cas présente une ou plusieurs portions permettant d'enfoncer et de repousser vers la profondeur le matériau de la feuille 1, 2, 3, 4 dans la zone destinée à loger le composant ou dans toute zone susceptible de présenter une surépaisseur, par exemple dans la zone du pont entre la bobine et le composant électrique. La zone de l'évidement peut être renforcée localement; il est aussi possible de remplir cet évidement par un matériau enrobant et maintenant le composant électronique.

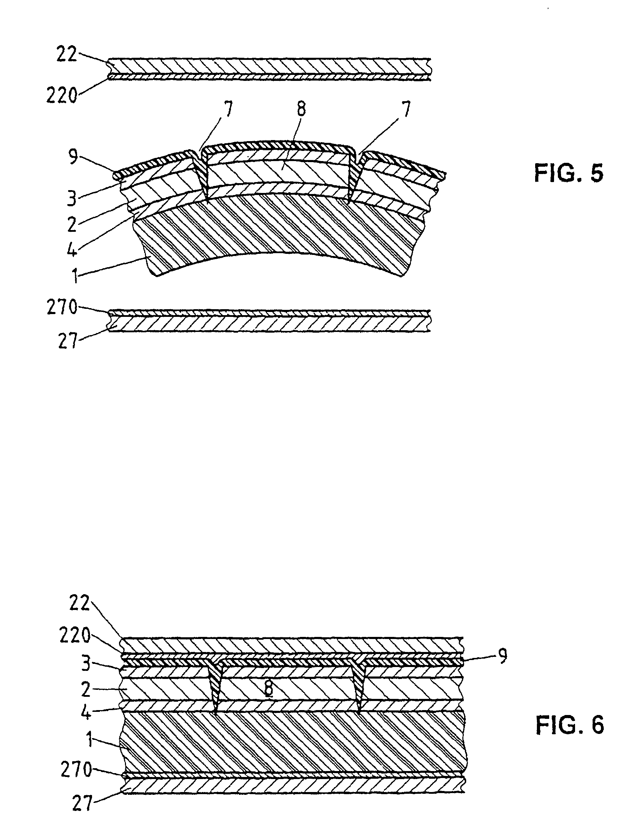

La figure 5 illustre l'étape suivante de fabrication de transpondeur selon l'invention. Au cours de cette étape, la feuille 1, 2, 3, 4 de l'invention, recouverte par la couche 9 remplissant au moins partiellement les entailles 7, est laminée entre (au moins) une feuille de protection supérieure 22 et (au moins) une feuille de protection inférieure 27. Chaque feuille de protection est assemblée de préférence sous pression par exemple au moyen d'une couche de colle 220, respectivement 270. La couche de colle 220 permettant d'assembler la feuille de protection supérieure 22 est de préférence suffisamment épaisse et liquide pour compenser les inégalités d'épaisseur à la surface de la carte, notamment au niveau de la bobine et du ou des composants électroniques, et pour remplir l'interstice résiduel dans les entailles 7. Les feuilles de protection 22, 27 peuvent aussi être laminées par pressage à chaud sans couche de colle 220, 270. Dans ce cas, le matériau fondu des feuilles contribue également à compenser les inégalités d'épaisseur et à remplir les entailles 7. En outre, de manière connue, des fenêtres par exemple pour des contacts électriques et des évidements pour loger les composants dans la carte peuvent être prévus dans la feuille 22 et/ou 27. La face externe des feuilles 22 et 27 est suffisamment lisse pour permettre une impression de la carte finie, dans le cas où les feuilles 22, 27 ne sont pas imprimées préalablement.

Dans un autre mode de réalisation de l'invention, on renonce à la feuille de protection inférieure 27. Dans ce cas, la surface externe inférieure de la carte est directement constituée par la surface de la couche diélectrique 1 qui doit présenter des qualités de surface suffisantes pour permettre une impression et, le cas échéant, un fonctionnement fiable dans des automates.

Dans un autre mode de réalisation, la carte à puce est réalisée en plaçant la feuille 1, 2, 3, 4 dans un moule et en injectant du matériau autour de cette feuille (surmoulage). Il peut être avantageux pour ce mode de réalisation de laminer une feuille de diélectrique supplémentaire 1 par-dessus l'assemblage 1, 2, 3, 4, de manière à surmouler une feuille aussi symétrique que possible. Dans tous les cas, la compensation du cintrage de la feuille est moins critique pour ce mode de réalisation.

La figure 6 illustre une coupe à travers une portion de la carte finie. On constate que, sous l'effet conjoint de la pression appliquée lors du laminage des feuilles de protection 22, 27 et de la rigidité de ces feuilles, le cintrage de la carte est supprimé, en sorte que le procédé permet d'obtenir des cartes rigoureusement planes. L'étape mentionnée de redressement de la feuille par compression avant le laminage des feuilles 22, 27 n'est généralement nécessaire que dans le cas où les feuilles 22, 27 sont laminées à froid

On remarquera que, dans les portions A, B, C dépourvues de pistes conductrices 2, 3, 4, 9, la couche 220 peut être laminée directement sur la couche diélectrique 1 ou, le cas échéant, sur la feuille mentionnée de compensation de hauteur. Une adhérence optimale est ainsi garantie.

On réalisera de préférence plusieurs cartes à puces à partir d'une seule feuille 1,2,3,4. Il est possible par exemple de répartir plusieurs dizaines de bobines, disposées en matrice, sur une seule feuille de taille suffisante ou sur un ruban continu. Les différentes bobines sur la feuille peuvent soit être usinées simultanément, au moyen d'un seul poinçon d'étampage de grande taille, soit successivement avec le même poinçon déplacé entre chaque découpe (stepper). Dans les deux cas, une opération non représentée de fractionnement de la feuille et de découpe des cartes individuelles est nécessaire après laminage des diverses couches.

Nous n'avons discuté ci-dessus que succinctement de la connexion du ou des composants électroniques avec les spires 8 de la bobine ainsi usinée. Les figures 7 et 8 permettent d'illustrer deux modes de réalisation de cette connexion, dans le cas où le transpondeur est constitué par une carte à puce comportant un circuit intégré 25 et une bobine 8.

Le circuit intégré 25, qui peut être logé dans un évidement non représenté d'une ou plusieurs de couches de la carte, est connecté aux deux extrémités de l'élément inductif 8. La connexion entre le circuit 25 et la spire interne de la bobine peut être faite directement dans le cas, représenté sur la figure 7, où le circuit 25 est disposé entre les spires de la bobine. La connexion avec la spire externe de la bobine 8 doit en revanche être faite par l'intermédiaire d'un pont 80 par-dessus les spires 8. Le pont pourrait par exemple être constitué par un simple fil soudé par-dessus ou par-dessous les pistes conductrices 8. Dans le cas d'un circuit à plusieurs couches conductrices, il est aussi possible d'utiliser une des couches métallisées pour effectuer le pont, ou d'intégrer le pont dans le substrat 1 avant laminage des couches conductrices 2.

Sur la figure 7, le pont est réalisé très simplement en décollant (après, le cas échéant, pulvérisation du matériau isolant 9) une longueur appropriée de la dernière spire de la bobine, et en repliant en la retournant si nécessaire cette longueur par-dessus les autres spires, ou éventuellement par-dessous les autres spires en passant à travers un trou de passage prévu à cet effet. L'isolation électrique entre la longueur 80 et les autres spires est réalisée uniquement par la couche pulvérisée 9 et/ou par la couche 3. L'extrémité de la longueur 80 peut être collée entre les spires, ou simplement maintenue grâce à la rigidité du matériau métallique 2. Une patte de connexion 250 du composant 25 est alors mise en contact électrique avec cette portion 80, respectivement avec la spire interne de la bobine. Dans une variante, il est aussi possible de replier par-dessus les spires une portion de la couche conductrice indépendante de la bobine.

Sur la figure 8, le circuit intégré 25 est assemblé à cheval par-dessus les spires 8. Cette disposition rend le pont 80 superflu ; une patte de connexion 250 du circuit 25 est directement reliée électriquement avec la spire externe de la bobine 8 tandis qu'une autre patte 250 est reliée directement avec la spire interne de cette bobine. Cette variante est particulièrement simple à réaliser, mais limite le choix de circuits 25 utilisables et présente l'inconvénient d'ajouter l'épaisseur de la bobine à celle du circuit 25 ou de nécessiter de préparer un évidemment ou un abaissement des spires à cet endroit.

Les pattes de connexion 250 peuvent être collées, soudées ou fixées par bonding avec les spires 8. On a toutefois observé dans des transpondeurs conventionnels qu'une telle soudure se casse parfois lorsque la carte est pliée ou déformée un grand nombre de fois. Pour pallier à ce risque, dans un mode de réalisation préférentiel de l'invention, les pattes de connexion 250 sont simplement posées par-dessus les spires 8, sans soudure ni fixation particulière. Le circuit intégré 25 est alors maintenu appuyé contre les pistes 8 par la couche de protection 22. Cette disposition permet aux pattes de coulisser légèrement par-dessus les pistes 8 lorsque la carte est pliée, et de reprendre leur position initiale lorsque la carte retrouve sa forme. En raison de l'élasticité de la couche de protection supérieure 22, les pattes 25 restent en permanence appuyées avec une certaine pression contre la portion de contact des spires 8, ce qui permet d'assurer un contact électrique de qualité même après de nombreux pliages et déformations de la carte.

Naturellement, il est important de veiller à ce que la zone des pistes 8 destinée à venir en contact avec les pattes du circuit 25 ne soit pas recouverte de matériau isolant 3 ou 9. Dans ce but, cette zone peut par exemple être protégée lors du laminage du film 2 et du sprayage du matériau 9. Il est aussi possible de retirer localement ces couches 3, 9 avant l'assemblage du circuit 25.

L'homme du métier constatera que cet aspect supplémentaire de l'invention est indépendant de la fabrication de bobine, et peut être utilisé pour connecter n'importe quel type de bobine enroulée ou usinée avec n'importe quel type de composant électronique,

Suivant l'application désirée et la place résiduelle disponible sur la carte, d'autres composants que le circuit intégré 25 et la bobine 8 peuvent être intégrés sur le circuit imprimé 21. Il est par exemple possible de placer sur le circuit un accumulateur (non représenté) qui pourra être rechargé depuis l'extérieur au moyen d'un élément inductif, par exemple de l'élément 23. Ces autres composants seront idéalement connectés mutuellement et avec les éléments 8 et 25 au moyen de pistes conductrices usinées de la manière décrite ci-dessus dans la ou les couches conductrices superficielles 2.

L'homme du métier constatera ici que contrairement à la plupart des techniques connues de l'art antérieur, la fabrication des pistes conductrices 8 sur le circuit imprimé par le procédé de l'invention crée remarquablement peu d'inégalités de surface qui sont en outre compensées par la colle ou lors de la fusion des couches supérieures. Il est donc relativement aisé d'assembler la feuille supérieure 22 en obtenant une surface externe rigoureusement plane.

D'autres méthodes de laminages de cartes à puces peuvent être utilisées avec des bobines de l'invention, par exemple les procédés faisant l'objet de la demande de brevet W094/22111, ou l'un des procédés de l'art antérieur évoqué dans cette demande.

Le procédé de l'invention peut être étendu à la fabrication de transpondeurs à circuit double face et/ou multicouche, c'est-à-dire comportant plusieurs couches de matériau conducteur 2 superposées et usinées de manière à définir plusieurs niveaux de pistes. Outre la fabrication de carte à puce, le procédé peut en outre être utilisé pour la fabrication de n'importe quel type de transpondeur, par exemple pour le marquage de pièces ou d'animaux ou pour la surveillance d'articles dans un magasin. Selon l'application, la forme et les caractéristiques de la bobine pourront être assez différentes. Dans le cas d'une carte à puce pour des applications de type transaction bancaire ou payement, une carte à puce munie d'une bobine permettant de communiquer avec l'extérieur à haute fréquence, de préférence avec une fréquence supérieure à 50KHz, par exemple 10MHz.

## Revendications

1. Procédé de fabrication de bobine pour transpondeur (20) comprenant les étapes suivantes :
- démarcation des différentes spires (8) d'une bobine dans une feuille (1, 2, 3, 4) comportant un substrat diélectrique (1) recouvert par au moins une couche conductrice (2) par étampage de ladite couche conductrice au moyen d'un poinçon d'étampage permettant de couper des entailles (7) séparant lesdites spires sans retrait de matière conductrice ni repoussement en profondeur en exerçant une pression latérale sur au moins un côté desdites spires.
- connexion d'au moins un composant électronique (25) avec lesdites spires (8),
**caractérisé en ce que**
ladite couche conductrice (2) est recouverte avant étampage par un film superficiel (3) destiné à faciliter l'étampage, et **en ce qu'**au moins un matériau isolant (9, 220) est inséré dans lesdites entailles (7) pour garantir une isolation électrique des différentes pistes conductrices (8).

2. Procédé selon l'une des revendications précédentes, **caractérisé en ce que** ledit outil de coupe est un poinçon d'étampage (5) présentant des surfaces de contact coupantes (6) avec la surface de la feuille (1, 2, 3, 4), lesdites surfaces coupants perforent et découpent la couche conductrice (2) sans retrait de matière.

3. Procédé selon l'une des revendications précédentes, **caractérisé en ce qu'**il comprend en outre une étape d'usinage dans ladite feuille d'au moins un logement destiné à loger ledit au moins un composant électronique (25).

4. Procédé selon la revendication précédente, **caractérisé par** une opération de remplissage dudit logement avec un matériau enrobant ledit composant électronique.

5. Procédé selon l'une des revendications précédentes **caractérisé en ce que** ledit substrat diélectrique comporte des renforts locaux dans la zone du composant électronique.

6. Procédé selon l'une des revendications précédentes, **caractérisé en ce que** ledit substrat diélectrique (1) comporte au moins un trou traversant servant de passage à une portion de la couche conductrice.

7. Procédé selon la revendication 1, **caractérisé en ce que** ledit matériau isolant (9) comporte un enduit, par exemple une laque, un vernis, une résine ou un produit préimprégné, appliqué sur ladite bobine (8) après étampage desdites entailles (7).

8. Procédé selon la revendication 1, **caractérisé en ce que** ledit matériau isolant (220) de remplissage des entailles comporte une colle d'assemblage pour une feuille de protection supplémentaire (22) collée sur ladite feuille après étampage.

9. Procédé selon l'une des revendications précédentes, **caractérisé en ce que** ladite feuille (1, 2, 3, 4) est cintrée de manière à écarter lesdites entailles (7) lors de l'insertion dudit matériau (9, 220).

10. Procédé selon la revendication précédente, **caractérisé en ce qu'**il comporte un étape de redressement de ladite feuille (1, 2, 3, 4) par compression.

11. Procédé selon l'une des revendications précédentes, **caractérisé en ce qu'**il comprend en outre une étape de pliage d'au moins une portion (80) de ladite couche conductrice de manière à créer au moins un pont électrique (80) par-dessus lesdites spires.

12. Procédé selon l'une des revendications précédentes, **caractérisé en ce que** ladite couche conductrice (2) est assemblée sur ledit substrat au moyen d'une colle (4) non permanente, et **en ce qu'**il comporte une étape de décollage d'au moins une portion (A, B, C) de ladite couche conductrice après ladite étape d'étampage d'entailles.

13. Procédé selon la revendication précédente, **caractérisé en ce que** ladite au moins une portion décollée comporte au moins la portion (A) de ladite couche conductrice entre lesdites spires de la bobine.

14. Procédé selon l'une des revendications 11 ou 12, **caractérisé en ce que** ladite au moins une portion décollée comporte au moins la portion (C) de ladite couche conductrice à l'extérieur desdites spires de la bobine.

15. Procédé selon l'une des revendications 11 à 13, **caractérisé en ce que** ladite au moins une portion décollée comporte au moins un segment (80) desdites spires.

16. Procédé selon la revendication précédente, **caractérisé en ce que** l'inductance de la bobine est ajustée après étampage par décollage d'une portion des spires et/ou par usinage desdites spires.

17. Procédé selon l'une des revendications 15 ou 16, **caractérisé en ce que**, après décollement d'un segment (80) desdites spires (8) préalablement recouvertes d'une couche isolante, ledit segment est utilisé pour constituer un pont électrique (80).

18. Procédé selon la revendication 1, **caractérisé en ce que** ladite couche conductrice est collée sur ledit substrat diélectrique uniquement en certaines portions, de manière à faciliter le décollage ultérieur des portions (A, B, C) résiduelles.

19. Procédé selon l'une des revendications précédentes, **caractérisé en ce qu'**il comporte une étape d'enfoncement de ladite couche conductrice (2, 3, 4) dans l'épaisseur du diélectrique (1) pour améliorer la planéité.

20. Procédé selon l'une des revendications 11 à 19, **caractérisé en ce qu'**il comporte une étape de laminage d'une feuille de diélectrique intermédiaire ayant sensiblement l'épaisseur de ladite couche conductrice (2, 3, 9) et dont la forme correspond à celle des portions (A, B, C) dépourvues de pistes, afin d'améliorer la planéité.

21. Procédé selon l'une des revendications précédentes, **caractérisé en ce qu'**il comporte une étape d'assemblage d'au moins un composant électronique (25) à cheval sur lesdites spires de la bobine.

22. Procédé selon l'une des revendications précédentes, **caractérisé en ce qu'**au moins un contact desdits composants électroniques (25) est directement connecté, sans soudure, sur les portions de contact des spires de la bobine (8) préalablement dépourvues de matière isolante.

23. Procédé de fabrication de transpondeur (20), comprenant les étapes suivantes :
- fabrication d'une bobine pour transpondeur selon le procédé d'une des revendications précédentes,
- assemblage d'au moins une feuille de protection (22, 27) recouvrant ladite bobine et ledit composant électronique (25).

24. Procédé selon la revendication précédente, **caractérisé en ce qu'**il comporte une étape d'assemblage d'une seconde feuille de protection (27) sur la face opposée à celle munie de la première feuille de protection.

## Patentansprüche

1. Herstellungsverfahren für eine Transponderspule (20), die folgenden Schritte umfassend:
- Abgrenzung der verschiedenen Windungen (8) einer Spule in einer Folie (1, 2, 3, 4), die ein nichtleitendes Substrat (1) umfasst, das von zumindest einer Leiterschicht (2) bedeckt ist, durch Stanzen der benannten Leiterschicht mittels eines Stanzstempels, der es gestattet, Einschnitte (7) zu schneiden, die die benannten Windungen voneinander trennen, und zwar ohne Schrumpfung des Leitermaterials und ohne ein Wegdrücken in die Tiefe, indem auf zumindest eine Seite der benannten Windungen ein seitlicher Druck ausgeübt wird,
- Verbindung von zumindest einem elektronischen Bauteil (25) mit den benannten Windungen (8),
**dadurch gekennzeichnet, dass**
die benannte Leiterschicht (2) vor dem Stanzen durch einen oberflächlichen Film (3) überdeckt wird, der dazu bestimmt ist, das Stanzen zu erleichtern, und dadurch, dass zumindest ein isolierendes Material (9, 220) in die benannten Einschnitte (7) eingefüllt wird, um eine elektrische Isolierung der verschiedenen Leiterbahnen (8) zu gewährleisten.

2. Verfahren gemäss einem der vorangehenden Ansprüche, **dadurch gekennzeichnet, dass** das benannte Schneidwerkzeug ein Stanzstempel (5) ist, der schneidende Berührungsflächen (6) mit der Oberfläche der Folie (1, 2, 3, 4) aufweist, wobei die benannten schneidenden Flächen die Leiterschicht (2) ohne Schrumpfung des Materials durchbohren und zerschneiden.

3. Verfahren gemäss einem der vorangehenden Ansprüche, **dadurch gekennzeichnet, dass** es ausserdem einen Schritt der Herausarbeitung von zumindest einem Raum in der benannten Folie umfasst, der dazu bestimmt ist, das zumindest eine elektronische Bauteil (25) unterzubringen.

4. Verfahren gemäss dem vorangehenden Anspruch, **gekennzeichnet durch** einen Arbeitsgang, bei dem der benannte Raum mit einem Material gefüllt wird, das das benannte elektronische Bauteil umhüllt.

5. Verfahren gemäss einem der vorangehenden Ansprüche, **dadurch gekennzeichnet, dass** das benannte nichtleitende Substrat lokale Verstärkungen im Bereich des elektronischen Bauteils umfasst.

6. Verfahren gemäss einem der vorangehenden Ansprüche, **dadurch gekennzeichnet, dass** das benannte nichtleitende Substrat (1) zumindest ein durchgehendes Loch umfasst, das als Durchlass für einen Teil der Leiterschicht dient.

7. Verfahren gemäss Anspruch 1, **dadurch gekennzeichnet, dass** das benannte isolierende Material (9) einen Aufstrich umfasst, zum Beispiel einen Lack, einen Firnis, ein Harz oder ein harzgetränktes Material, das nach dem Stanzen der benannten Einschnitte (7) auf die benannte Spule (8) aufgebracht wird.

8. Verfahren gemäss Anspruch 1, **dadurch gekennzeichnet, dass** das benannte isolierende Material (220) für die Füllung der Einschnitte einen Aufbaukleber für eine zusätzliche Schutzfolie (22) umfasst, die nach dem Stanzen auf die benannte Folie aufgeklebt wird.

9. Verfahren gemäss einem der vorangehenden Ansprüche, **dadurch gekennzeichnet, dass** die benannte Folie (1, 2, 3, 4) so gekrümmt ist, dass die benannten Einschnitte (7) beim Einbringen des benannten Materials (9, 220) auseinanderspreizen.

10. Verfahren gemäss dem vorangehenden Anspruch, **dadurch gekennzeichnet, dass** es einen Schritt der Ausrichtung der benannten Folie (1, 2, 3, 4) durch Zusammendrücken umfasst.

11. Verfahren gemäss einem der vorangehenden Ansprüche, **dadurch gekennzeichnet, dass** es ausserdem einen Schritt des Faltens von zumindest einem Abschnitt (80) der benannten Leiterschicht in der Weise umfasst, dass zumindest ein elektrischer Steg (80) über die benannten Windungen hinweg geschaffen wird.

12. Verfahren gemäss einem der vorangehenden Ansprüche, **dadurch gekennzeichnet, dass** die benannte Leiterschicht (2) mittels eines nicht dauerhaften Klebers (4) auf das benannte Substrat aufgebracht wird, und dadurch, dass es einen Schritt des Ablösens von zumindest einem Teil (A, B, C) der benannten Leiterschicht nach dem benannten Schritt des Stanzens von Einschnitten umfasst.

13. Verfahren gemäss dem vorangehenden Anspruch, **dadurch gekennzeichnet, dass** der benannte, zumindest eine abgelöste Teil zumindest den Teil (A) der benannten Leiterschicht zwischen den benannten Windungen der Spule umfasst.

14. Verfahren gemäss einem der Ansprüche 11 oder 12, **dadurch gekennzeichnet, dass** der benannte, zumindest eine abgelöste Teil zumindest den Teil (C) der benannten Leiterschicht ausserhalb der benannten Windungen der Spule umfasst.

15. Verfahren gemäss einem der Ansprüche 11 bis 13, **dadurch gekennzeichnet, dass** der benannte, zumindest eine abgelöste Teil zumindest ein Segment (80) der benannten Windungen umfasst.

16. Verfahren gemäss dem vorangehenden Anspruch, **dadurch gekennzeichnet, dass** die Induktivität der Spule nach dem Stanzen durch Ablösen eines Teils der Windungen und/oder Bearbeitung der benannten Windungen eingestellt wird.

17. Verfahren gemäss einem der Ansprüche 15 oder 16, **dadurch gekennzeichnet, dass** nach Ablösen eines Segments (80) der benannten Windungen (8), die im Voraus mit einer isolierenden Schicht überzogen wurden, das benannte Segment dafür verwendet wird, einen elektrischen Steg (80) zu bilden.

18. Verfahren gemäss Anspruch 1, **dadurch gekennzeichnet, dass** die benannte Leiterschicht nur in bestimmten Abschnitten auf das benannte nichtleitende Substrat aufgeklebt wird, um das spätere Ablösen von verbleibenden Teilen (A, B, C) zu erleichtern.

19. Verfahren gemäss einem der vorangehenden Ansprüche, **dadurch gekennzeichnet, dass** es einen Schritt des Eindrückens der benannten Leiterschicht (2, 3, 4) in das Dielektrikum (1) umfasst, um die Flachheit zu verbessern.

20. Verfahren gemäss einem der Ansprüche 11 bis 19, **dadurch gekennzeichnet, dass** es einen Schritt des Aufwalzens einer nichtleitenden Zwischenfolie umfasst, die im Wesentlichen die Dicke der benannten Leiterschicht (2, 3, 9) hat und deren Gestalt der der Teile (A, B, C) ohne Leiterbahnen entspricht, um die Flachheit zu verbessern.

21. Verfahren gemäss einem der vorangehenden Ansprüche, **dadurch gekennzeichnet, dass** es einen Schritt der Montage von zumindest einem elektronischen Bauteil (25) direkt über den benannten Spulenwindungen umfasst.

22. Verfahren gemäss einem der vorangehenden Ansprüche, **dadurch gekennzeichnet, dass** zumindest ein Anschluss der benannten elektronischen Bauteile (25) ohne Löten direkt mit den kontaktierenden Teilen der Windungen der Spule (8) verbunden wird, die im Voraus vom isolierenden Material befreit wurden.

23. Fertigungsverfahren für einen Transponder (20), die folgenden Schritte umfassend:
- Fertigung einer Transponderspule gemäss dem Verfahren eines der vorangehenden Ansprüche,
- Aufbringen von zumindest einer Schutzfolie (22, 27), die die benannte Spule und das benannte elektronische Bauteil (25) bedeckt.

24. Verfahren gemäss dem vorangehenden Anspruch, **dadurch gekennzeichnet, dass** es einen Schritt des Aufbringens einer zweiten Schutzfolie (27) auf der Seite umfasst, die von der mit der ersten Schutzfolie versehenen abgewandt ist.

## Claims

1. Method of producing a coil for a transponder (20) comprising the following steps:
demarcating the various turns (8) of a coil in a sheet (1, 2, 3, 4) including a dielectric substrate (1) covered by at least one conducting layer (2) by stamping the said conducting layer using a stamping die to allow incisions (7) to be cut, separating the said turns without removal of conducting material or depth wise indentation by exerting a lateral pressure on at least one side of the conducting path,
connecting at least one electronic component (25) with the said turns (8),
**characterized in that**
the said conducting layer (2) is covered before stamping with a superficial film (3) intended to make stamping easier, and **in that** at least one insulating material (9, 220) is inserted in the said incisions (7) to guarantee electrical isolation of the various conducting tracks (8).

2. Method according to claim 1, **characterized in that** the said cutting tool is a stamping die (5) having sharp-edged surfaces (6) for contact with the surface of the sheet (1, 2, 3, 4), said sharp-edged surfaces (6) perforate and cut the superficial conductive layer without removal of material.

3. Method according to one of the preceding claims, **characterized in that** it further comprises a step of machining in the said sheet at least one accommodation intended to accommodate the said at least one electronic component (25).

4. Method according to the preceding claim, **characterized by** an operation of filling the said accommodation with a material that coats the said electronic component.

5. Method according to one of Claims 2 to 4, **characterized in that** the said dielectric substrate includes local reinforcements in the region of the electronic component.

6. Method according to one of preceding claims, **characterized in that** the said dielectric substrate (1) includes at least one through-hole which serves as passage for a part of the conducting layer.

7. Method according to Claim 1, **characterized in that** the said insulating material (9) comprises a coating, for example, a lacquer, a varnish, a resin or a preimpregnated product, applied to the said coil (8) after the stamping of the said incisions (7).

8. Method according to Claim 1, **characterized in that** the said insulating material (220) for filling the incisions comprises an adhesive for mounting an additional protective sheet (22), glued onto the said sheet after stamping.

9. Method according to one of the preceding claims, **characterized in that** the said sheet (1, 2, 3, 4) is bent so as to space apart the said incisions (7) upon insertion of the said material (9, 220).

10. Method according to the preceding claim, **characterized in that** it comprises a step of straightening the said sheet (1, 2, 3, 4) by compression.

11. Method according to one of the preceding claims, **characterized in that** it further comprises a step of bending over at least a portion (80) of the said conductive layer in such a way to create at least one electrical bridge (80) over the said turns.

12. Method according to one of the preceding claims, **characterized in that** the said conducting layer (2) is mounted on the said substrate by means of a non-permanent adhesive (4), and **in that** the method comprises a step of unsticking at least one portion (A, B, C) of the said conducting layer after the said step of stamping incisions.

13. Method according to the preceding claim, **characterized in that** the said at least one unstuck portion includes at least the portion (A) of the said conducting layer between the said turns of the coil.

14. Method according to one of Claims 11 or 12, **characterized in that** the said at least one unstuck portion includes at least the portion (C) of the said conducting layer outside the said turns of the coil.

15. Method according to one of Claims 11 to 13, **characterized in that** the said at least one unstuck portion includes at least a segment (80) of the said turns.

16. Method according to the preceding claim, **characterized in that** the inductance of the coil is adjusted after stamping by unsticking a part of the turns and/or by machining said turns .

17. Method according to one of Claims 15 or 16, **characterized in that**, after a segment (80) of the said turns (8) previously covered with an insulating layer has been unstuck, the said segment is used to form an electrical bridge (80).

18. Method according to Claim 2, **characterized in that** the said conducting layer is glued on the said dielectric substrate only in certain portions, so as to facilitate the subsequent unsticking of residual portions (A, B, C).

19. Method according to one of the preceding claims, **characterized in that** it comprises a step of pressing the said conducting layer (2, 3, 4) into the thickness of the dielectric (1) to improve the flatness.

20. Method according to one of Claims 11 to 19, **characterized in that** it comprises a step of laminating an intermediate dielectric sheet having substantially the thickness of the said conducting layer (2, 3, 9) and whose shape corresponds to that of the portions (A, B, C) without tracks in order to improve the flatness.

21. Method according to one of the preceding claims, **characterized in that** it comprises a step of mounting at least one electronic component (25) straddling the said turns of the coil.

22. Method according to one of the preceding claims, **characterized in that** at least one contact of the said electronic components (25) is positioned directly, without soldering, on the contact portions of the turns of the coil (8) for which isolating material is previously removed.

23. Method of producing a transponder (20), comprising the following steps:
- producing a transponder coil according to the method of one of the preceding claims,
- mounting at least one protective sheet (22, 27) covering the said coil and the said electronic component (25).

24. Method according to the preceding claim, **characterized in that** it comprises a step of mounting a second protective sheet (27) on the opposite face to the one provided with the first protective sheet.
